# EUROPÄISCHE PATENTANMELDUNG

(11) **EP 1 225 642 A1**
(43) Veröffentlichungstag der Anmeldung: **24.07.2002**
(21) Anmeldenummer: 02000127.7
(22) Anmeldetag: 04.01.2002
(51) Int. Cl.: H01L 31/048

(54) **Solarmodule mit Polyurethaneinbettung und ein Verfahren zu deren Herstellung**

(30) Priorität: 17.01.2001 DE 10101770
(71) Anmelder: Bayer Aktiengesellschaft, 51368 Leverkusen (DE)
(72) Erfinder: Dörner, Karl-Heinz, 50259 Pulheim (DE); Ehbing, Hubert, Dr., 46354 Südlohn (DE); Hässler, Christian, Dr., 47800 Krefeld (DE); Ramthun, Jürgen, 51469 Bergisch Gladbach (DE); Stollwerck, Gunther, Dr., 47800 Krefeld (DE); Eiben, Robert, Dr., 68623 Lampertheim (DE); Niedermeyer, Michael, 68804 Alzlussheim (DE); Schuster, Peter, 67122 Altrip (DE)

(57) **Zusammenfassung**

Die Erfindung betrifft Solannodule, bei denen die Frontseite (1) aus transparentem Polyurethan besteht.

## Beschreibung

Die Erfindung betrifft Solarmodule, deren Frontseite aus transparentem Polyurethan besteht und ein Verfahren zu deren Herstellung.

Unter Solarmodulen versteht man photovoltaische Bauelemente zur direkten Erzeugung von elektrischem Strom aus Sonnenlicht. Schlüsselfaktoren für eine kosteneffiziente Erzeugung von Solarstrom sind der Wirkungsgrad der verwendeten Solarzellen, sowie die Herstellkosten und die Haltbarkeit der Solarmodule.

Ein Solarmodul besteht üblicherweise aus einem Verbund aus Glas, verschalteten Solarzellen, einem Einbettmaterial und einer Rückseitenkonstruktion. Die einzelnen Schichten des Solarmoduls haben folgende Funktionen zu erfüllen.

Das Frontglas dient dem Schutz vor mechanischen und Witterungseinflüssen. Es muss höchste Transparenz aufweisen, um Absorptionsverluste im optischen Spektralbereich von 300 nm bis 1150 nm und damit Wirkungsgradverluste der üblicherweise zur Stromerzeugung eingesetzten Silicium-Solarzellen möglichst gering zu halten. Normalerweise wird gehärtetes, eisenarmes Weißglas (3 oder 4 mm stark) verwendet, dessen Transmissionsgrad im obigen Spektralbereich bei 90-92 % liegt.

Das Einbettmaterial (meist werden EVA (Ethyl-Vinylacetat)-Folien verwendet) dient zur Verklebung des gesamten Modulverbundes. EVA schmilzt während eines Laminiervorgangs bei etwa 150°C, fließt in die Zwischenräume der verlöteten Solarzellen und wird thermisch vernetzt. Eine Bildung von Luftblasen, die zu Reflexionsverlusten führen, wird durch eine Laminierung unter Vakuum vermieden.

Die Modulrückseite schützt die Solarzellen und das Einbettmaterial vor Feuchtigkeit und Sauerstoff. Außerdem dient sie als mechanischer Schutz vor Verkratzung etc. beim Montieren der Solarmodule und als elektrische Isolation. Die Rückseitenkonstruktion besteht ebenfalls entweder aus Glas, meist aber aus einer Verbundfolie. Im wesentlichen werden dabei die Varianten PVF (Polyvinylfluorid)-PET (Polyethylenterephthalat)-PVF oder PVF-Aluminium-PVF eingesetzt.

Die im Solarmodulbau eingesetzten Kapselungsmaterialien müssen insbesondere gute Barriereeigenschaften gegen Wasserdampf und Sauerstoff aufweisen. Durch Wasserdampf oder Sauerstoff werden die Solarzellen selbst nicht angegriffen, aber es kommt zu einer Korrosion der Metallkontakte und einer chemischen Degradation des EVA-Einbettmaterials. Ein zerstörter Solarzellenkontakt führt zu einem Komplettausfall des Moduls, da normalerweise alle Solarzellen in einem Modul elektrisch seriell verschaltet werden. Eine Degradation des EVA zeigt sich an einer Vergilbung des Moduls, verbunden mit einer entsprechenden Leistungsreduktion durch Lichtabsorption sowie einer visuellen Verschlechterung. Heute werden etwa 80 % aller Module mit einer der beschriebenen Verbundfolien auf der Rückseite verkapselt, bei etwa 15 % der Solarmodule wird Glas für Vorder- und Rückseite verwendet. In diesem Falle kommen als Einbettmaterial anstatt EVA teilweise hochtransparente, allerdings nur langsam (mehrere Stunden) härtende Gießharze zum Einsatz.

Um trotz der relativ hohen Investitionskosten konkurrenzfähige Stromgestehungskosten von Solarstrom zu erreichen, müssen Solarmodule lange Betriebszeiten erreichen. Heutige Solarmodule sind daher auf eine Lebensdauer von 20-30 Jahren ausgelegt. Neben hoher Witterungsstabilität werden große Anforderungen an die Temperaturbelastbarkeit der Module gestellt, deren Temperatur im Betrieb zyklisch zwischen 80°C bei voller Sonneneinstrahlung und Temperaturen unterhalb des Gefrierpunkts schwanken kann. Dementsprechend werden Solarmodule umfangreichen Stabilitätstests unterzogen (Normtests nach IEC 1215), zu denen Witterungstests (UV-Bestrahlung, Damp Heat, Temperaturwechsel), aber auch Hagelschlag- und Tests des elektrischen Isolationsvermögens zählen.

Auf den Modulbau entfällt mit 30 % der Gesamtkosten ein relativ hoher Anteil der Herstellkosten für Photovoltaikmodule. Dieser große Anteil der Modulfertigung ist durch hohe Materialkosten (hagelschlagsicheres 3-4 mm starkes Frontglas, Rückseitenmehrschichtfolie) und durch lange Prozesszeiten, d.h. gering Produktivität bedingt. Noch immer werden häufig die oben beschriebenen Einzelschichten des Modulverbunds in Handarbeit zusammengestellt und ausgerichtet. Zusätzlich führt das relativ langsame Aufschmelzen des EVA-Schmelzklebers und die Lamination des Modulverbunds bei ca. 150°C und unter Vakuum zu Zykluszeiten von etwa 20-30 Minuten pro Modul.

Durch die relativ dicke Frontglasscheibe (3-4 mm) weisen konventionelle Solarmodule zudem ein hohes Gewicht auf, dass wiederum stabile und teure Haltekonstruktionen nötig macht. Auch ist die Wärmeabfuhr bei heutigen Solarmodulen nur unbefriedigend gelöst. Bei voller Sonnenbestrahlung heizen sich die Module auf bis zu 80°C auf, was zu einer temperaturbedingten Verschlechterung des Solarzellenwirkungsgrads und damit letztlich zu einer Verteuerung des Solarstroms führt.

Verschiedene Ansätze zu Reduktion der Modulherstellkosten durch kostengünstigere, d.h. vorrangig schnellere Herstellverfahren konnten sich bisher nicht durchsetzen. In den Patentanmeldungen US-A-4,830,038 und US-A-5,008,062 wird die schnelle Umschäumung der Modulrückseite von Dünnschicht-Solarmodulen durch Polyurethanschäume im RIM (Reaction Injection Moulding)-Verfahren beschrieben. Diese Dünnschichtsolarzellen werden (z.B. durch chemische Gasphasenabscheidung) direkt auf die Rückseite des Frontglases des Solarmoduls abgeschieden, wodurch die Notwendigkeit eines Einbettmaterials für die Solarzellen zwischen Vorder- und Rückseite des Moduls entfällt. Derzeit werden allerdings nur etwa 10 % aller Solarzellen in Dünnschichttechnik hergestellt, während der überwiegende Teil auf der Technologie kristalliner Siliciumscheiben beruht.

Aufgabe der Erfindung war die Entwicklung von Photovoltaikmodulen, die sich durch eine schnelle und kostengünstige Herstelltechnik sowie ein niedriges Gewicht auszeichnen sowie ein einfaches Verfahren zu deren Herstellung.

Die Aufgabe wird erfindungsgemäß gelöst durch ein Solarmodul, bei dem die Frontseite aus transparentem Polyurethan besteht.

Polyurethan bietet im Vergleich zu heute im Solarmodulbau eingesetzten Materialien trotz hoher Witterungsstabilität den Vorteil geringer Materialkosten, einer niedrigen Dichte und damit eines niedrigen Gewichts und schneller (einige Minuten) Verarbeitbarkeit bei geringen Temperaturen um 100°C.

In einer bevorzugten Ausführungsform sind die Solarzellen vollständig in transparentes Polyurethan eingebettet. Es können aber auch z. B. ein transparentes Polyurethan für die Frontseite und ein opakes Polyurethan für die Rückseite eingesetzt werden.

Unter einem transparenten Polyurethan soll dabei verstanden werden, dass das Polyurethan bei Schichtdicken von 1 mm im Wellenlängenbereich zwischen 400 nm und 900 nm eine Transmission von >85 % aufweist. Transparente Polyurethansysteme werden beispielsweise hergestellt aus aliphatischen Polyisocyanaten, beispielsweise niedrigviskose Hexamethylendiisocyanat(HDI)-Trimerisate mit einer Viskosität von 1000-3000 mPa·s bei 23°C, einem NCO-Gehalt von 21-25 % und einem Äquivalentgewicht von 170-190 g/mol bei einer Dichte von 1.0-1.2 g/cm³) und niedrigviskosen Polyesterpolyolen (Viskosität bei 23°C 1500-2500 mPa·s, Hydroxylzahl 480-560, Äquivalentgewicht 100-120 g/mol bei einer Dichte von 1.0-1.2 g/cm³). Ein geeignetes transparentes Polyurethansystem ist beispielsweise das System Bayflex® VP.PU 14IF02/VP.PU 18IF11 der Bayer AG.

Unter einem opaken Polyurethan soll dabei ein für sichtbares Licht undurchlässiges z.B. schwarz gefärbtes Standard-Polyurethan verstanden werden. Geeignete opake Polyurethansysteme sind beispielsweise das System Bayflex® VP.PU 43IF13/VP.PU 0833 der Bayer AG oder das System Baydur® VP.PU 71BD03/VP.PU 26IK01 der Bayer AG.

Für die Rückseite des Moduls können neben opaken Polyurethansystemen auch Kunststoffe (z.B. Polycarbonat, Polymethylmethacrylat, Fluorkunststoffe), glasfaserverstärkte Kunststoffe oder Metall-Kunststoff-Mehrschichtsysteme verwendet werden.

Die mechanische Stabilität des Moduls kann sowohl durch die Rück-, als auch die Vorderseite gewährleistet werden. Hauptanforderung der Vorderseite des Solarmoduls ist eine hohe Transparenz im sichtbaren und infraroten Spektralbereich von 300 nm bis etwa 1500 nm, um einen hohen photoelektrischen Wirkungsgrad der Solarzellen sicherzustellen. Vorder- und Rückseite des Moduls müssen beide generell hohe Witterungsstabilität z.B. gegen UV-Strahlung aufweisen und die eingebetteten Solarzellen durch geeignete Barriereeigenschaften (etwa gegen Wasserdampf und Sauerstoff) vor Korrosion schützen.

Für die Herstellung transparenter Polyurethansysteme zur Frontabdeckung der Solarmodule können aliphatische Polyisocyanate und auf der Polyolseite Caprolacton-Polyole einer Viskosität bei 23°C von 600-1000 mPa·s, einer Hydroxylzahl von 290-340, einem Äquivalentgewicht von 500-600 g/mol, einer Dichte von 1.0-1.2 g/cm³ eingesetzt werden, die ein verbessertes Alterungsverhalten in Bezug auf die Thermo-Oxidation des Polyurethans, sowie eine höhere UV-Stabilität besitzen. Zur weiteren Erhöhung der UV-Stabilität können zusätzlich Amine oder Phenole in einer Konzentration von etwa 1 % zugesetzt werden.

Für die Langzeitstabilität von Solarmodulen sind die durch wechselnde Temperaturen und unterschiedliche Ausdehnungskoeffizienten der verwendeten Materialien bedingten thermischen Spannungen, die zu einer Delaminierung oder sogar Zerstörung des Modulverbunds führen können, von besonderer Bedeutung.

Bevorzugt enthält das für die Rückseite verwendbare opake Polyurethan Füllstoffe, so dass der Wärmeausdehnungskoeffizient des Polyurethans reduziert und damit die Differenz der Ausdehnungskoeffizienten zwischen Solarzellen (meist Silicium, Ausdehnungskoeffizient ca. 3×10⁻⁶ K⁻¹) und Polyurethan (Ausdehnungskoeffizient 100-200×10⁻⁶ K⁻¹) verringert wird. Zur Reduktion des Wärmeausdehnungskoeffizienten des opaken Polyurethans können Füllstoffe wie Kreide, Glasplättchen oder Silikate bei Füllstoffkonzentrationen im Polyurethansystem von 10 bis 25 % verwendet werden.

In einer bevorzugten Ausführungsform enthält das Polyurethan Zusatzstoffe, die die Wärmeleitfähigkeit erhöhen (z.B. pulverförmiges Kupfer).

Dadurch wird der Forderung einer effizienten Kühlung der Solarmodule Rechnung getragen, die allgemein zu einer Erhöhung des Solarzellen-Wirkungsgrads führt. Alternativ kann die Oberfläche des Polyurethans, insbesondere dessen Rückseite, auch in Form von Kühlrippen ausgestaltet sein.

In einer bevorzugten Ausführungsform enthalten die Solarmodule zusätzliche Befestigungs- und/oder Versteifungselemente und/oder elektrische Funktionselemente.

Typische Elemente sind Befestigungsklammern zur späteren Montage der Solarmodule, elektrische Anschlussdosen und stab-, platten- oder gitterförmige Versteifungselemente aus Kunststoff oder metallischen Werkstoffen.

Diese zusätzlichen Elemente können bereits während des Polyurethan-Formgebungsprozesses in die Modulkonstruktion integriert und dabei auch zur mechanischen Stabilisierung der Solarzellen innerhalb des Werkzeugs verwendet werden.

In einer bevorzugten Ausführungsform stellt das zusätzliche Funktionselement die Modulrückseite dar und besitzt eine Formgebung (z.B. Nuten, Vertiefungen), die eine einfache Fixierung oder Befestigung der Solarzellen für den Polyurethan-Formgebungsprozess erlaubt. Die Modulrückseite kann z.B. aus einer tiefziehfähigen Verbundfolie bestehen. Diese wird entweder separat umgeformt und die Solarzellen einschließlich der Verbindungselemente werden anschließend eingebracht. Oder die Verbundfolie wird zusammen mit den Solarzellen tiefgezogen, so dass eine Fixierung auf und durch die Rückseite unmittelbar entsteht.

In einer bevorzugten Ausführungsform weisen die Solarmodule eine texturierte Oberfläche, insbesondere der Vorderseite, auf.

Polyurethane weisen beispielsweise gegenüber Glas den Vorteil einfacherer mechanischer Bearbeitbarkeit bzw. einfacher Formbarkeit schon beim Herstellprozess auf. Dieser Vorteil kann zu einer Texturierung der Oberfläche verwendet werden, die durch schräg dem Licht zugewandten Flächen zu einer erhöhten Lichtabsorption und damit zu einer Wirkungsgraderhöhung der Solarmodule führt.

Als Solarzellen können sowohl scheibenförmige Solarzellen als auch Dünnschicht-Solarzellen eingesetzt werden.

Bei Einsatz von Dünnschicht-Solarzellen kann die Abscheidung der Solarzellen auf geeigneten Trägern, beispielsweise aus Glas, Kunststoff oder Keramik erfolgen. Die Dünnschicht-Solarzellen auf diesen Trägern werden dann komplett in transparentes Polyurethan eingebettet, wobei das Polyurethan den Schutz vor mechanischen Einwirkungen und Witterungseinflüssen sicherstellt. Es kann auch der Träger der Dünnschicht-Solarzellen als Rückseite des Moduls fungieren und nur die Vorderseite des Moduls aus Polyurethan hergestellt werden.

Die Herstellung der erfindungsgemäßen Solarmodule kann durch ein Verfahren erfolgen, bei dem das transparente Polyurethan mittels eines RIM-Verfahrens (Reaction Injection Moulding), eines Gießverfahrens, eines Spritzverfahrens oder Kombinationen daraus auf die Solarzellen aufgetragen wird. Die Verfahren sind beispielsweise im Kunststoffhandbuch Nr. 7 "Polyurethane" von G. Oertel, Carl Hanser Verlag 1993 beschrieben (Seiten 139-152 (allgemeine Beschreibung und Gießverfahren), S. 356-368 (RIM-Verfahren), S. 333-334 (Spritzverfahren)). Zusätzliche Angaben zur Verarbeitung speziell transparenter Polyurethansysteme finden sich in EP-A1-0 978 523.

Die Solarzellen werden so in einem Werkzeug positioniert, dass die optisch aktive Seite dem Formhohlraum, der sogenannten Kavität, zugewandt ist. Das Reaktionssystem wird anschließend vorzugsweise mit einem Hochdruckverfahren in die Kavität gespritzt und bildet die transparente Abdeckung der Solarzellen. Alternativ kann auch ein Niederdruckverfahren oder ein druckloses Gießverfahren eingesetzt werden. Um eine blasenfreie Solarzellenabdeckung zu erhalten, sollten die Ausgangskomponenten das Reaktionssystem vor der Verarbeitung entgast werden. Ferner sind beim Eintrag des Reaktionssystems in die Kavität starke Strömungsumlenkungen und große Drucksprünge zu vermeiden. Der Werkzeuginnendruck in der Kavität ist so zu bemessen, dass entstandene Gasblasen komprimiert werden. Dieser Druck ist abhängig von der Größe der Kavität, der Viskosität des Reaktionssystems und der Löslichkeit des Gases im System. Der Werkzeuginnendruck kann nachträglich durch eine Kompression im gleichen oder einem weiteren Werkzeug erhöht werden.

In einer geeigneten Ausführungsform erfolgt die Herstellung der erfindungsgemäßen Solarmodule durch ein Verfahren bei dem die Solarzellen in einem Schritt mit transparentem Polyurethan umspritzt werden.

In einer anderen bevorzugten Ausführungsform erfolgt die Herstellung der erfindungsgemäßen Solarmodule durch ein Verfahren, bei dem transparentes Polyurethan in einem Schritt auf bereits auf einem als Modulrückseite dienenden Bauteil fixierte Solarzellen aufgespritzt wird.

In einer weiteren geeigneten Ausführungsform erfolgt die Herstellung der erfindungsgemäßen Solarmodule durch ein Verfahren, bei dem in einem ersten Schritt die transparente Polyurethan-Frontseite und in einem zweiten Schritt die Polyurethan-Rückseite oder in einem ersten Schritt die Rückseite und in einem zweiten Schritt die transparente Frontseite auf die Solarzellen aufgespritzt oder gegossen werden.

In einer bevorzugten Ausführungsform erfolgt die Herstellung der erfindungsgemäßen Solarmodule durch ein Verfahren, bei dem Befestigungs- und Versteifungselemente, sowie elektrische Funktionselemente in die Kavität eingebracht werden und durch Umspritzen mit dem Polyurethan-System am Bauteil befestigt sind. Die Befestigungs- oder Versteifungselemente werden dabei vor dem Umspritzen in einer dem Fachmann geläufigen Weise im Werkzeug an den entsprechenden Stellen positioniert (siehe z.B. Kunststoffhandbuch Nr. 7 "Polyurethane" von G. Oertel, Carl Hanser Verlag 1993, Seiten 397-400).

Anhand nachstehender Figuren wird die Erfindung beispielhaft näher erläutert. Es zeigen
- Figur 1 ein Solarmodul, bei dem die Solarzellen vollständig in identisches Polyurethanmaterial eingebettet sind,
- Figur 2 ein Solarmodul, bei dem die Solarzellen in zwei verschiedene Polyurethanmaterialien eingebettet sind,
- Figur 3 ein Solarmodul, dessen Fronseite aus transparentem Polyurethan und dessen Rückseite aus einem Formteil mit Fixierung der Solarzellen besteht.

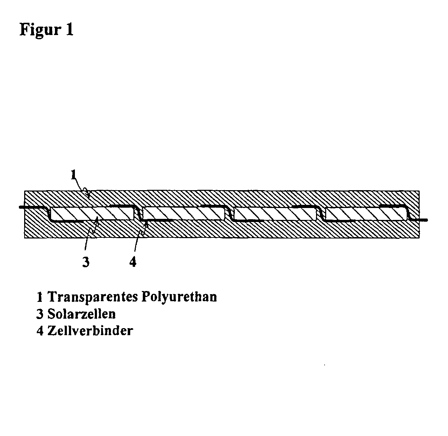

In Figur 1 besteht die Anordnung aus einem transparenten Polyurethan-Formteil 1, in das die über Zellverbinder 4 verbundenen Solarzellen 3 eingebettet sind.

Besonderer Vorteil dieser Konstruktion ist die Möglichkeit einer schnellen und witterungsstabilen Einbettung der Solarzellen in nur einem Arbeitsgang.

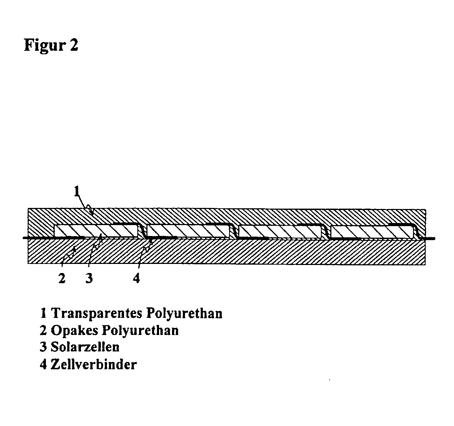

In Figur 2 besteht die Anordnung aus einem transparenten Polyurethan-Formteil 1 als Vorderseite und einem opaken Polyurethan-Formteil 2 als Rückseite. In die Vorderseite 1 sind die über Zellverbinder 4 verbundenen Solarzellen 3 eingebettet. Die Rückseite kann die mechanische Stabilität sicherstellen.

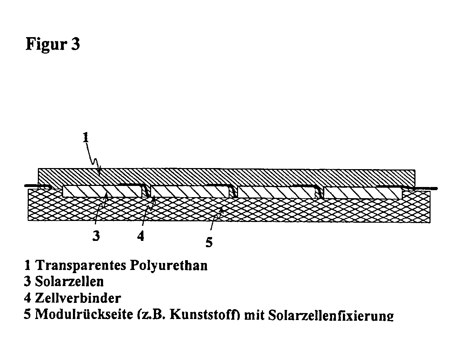

In Figur 3 besteht die Anordnung aus einem transparenten Polyurethan-Formteil 1 und einer Modulrückseite 5. Die Modulrückseite 5 weist eine Formgebung (z.B. Nuten, Vertiefungen) auf, die zur Fixierung der Solarzellen 3 und der Zellverbinder 4 während des Aufspritzens oder -gießens des transparenten Polyurethans geeignet ist.

### Beispiele

### Beispiel 1

Bei der Herstellung von mittels transparentem Polyurethan im RIM-Verfahren gekapselten Solarzellen (für Versuchszwecke zwei miteinander verlötete Solarzellen mit einer Fläche von je ca. 5×5 cm²) werden diese zunächst im Werkzeug auf Stützen positioniert. Nach dem Schließen des Werkzeuges wird das Reaktionsgemisch Bayflex® VP.PU 14IF02/VP.PU 18IF11 der Bayer AG injiziert und umspült die Solarzelle, wobei die Stützen mit eingeschlossen werden.

Für das transparente Polyurethansystem (Bayflex® VP.PU 14IF02/VP.PU 18IF11 der Bayer AG) wurde ein aliphatisches Polyisocyanat (niedrigviskoses HDI-Trimerisat, Viskosität bei 23°C 1200 mPa·s, NCO-Gehalt 23 %, monomeres HDI <0.25 %, Äquivalentgewicht 183 g/mol, Dichte 1.16 g/cm³) in Kombination mit einem kurzkettigen Polyesterpolyol (Viskosität bei 23°C ca. 1900 mPa·s, Hydroxylgehalt 16 % bzw. Hydroxylzahl 528, Wassergehalt <0.2 %, Äquivalentgewicht 106 g/mol, Dichte 1.05 g/cm³) verwendet. Als Katalysator wurde 1 % Dibutyl-Zinn-Dilaurat (DBTL) bezogen auf die Gesamtmenge eingesetzt.

Im Rahmen von Vorversuchen wurde als Stützkörper eine glasfaserverstärkte Polycarbonatplatte (Abmessungen 15×15 cm²) als Modulrückseite verwendet, auf der die Solarzellen aufgeklebt waren. Die werkzeugabhängige Injektionsgeschwindigkeit des Reaktionsgemisches wurde so gewählt, dass einerseits eine ausreichende Vermischung im Mischkopf gewährleistet war, andererseits die Strömungsgeschwindigkeit nicht so hoch war, dass das im System gelöste Gas durch Scherung und hohe Strömungsgeschwindigkeiten Gasblasen bildete, die im Polyurethan verbleiben und durch Lichtstreuung die Transparenz der Verkapselung reduzieren. Die Injektionsgeschwindigkeit des Reaktionssystems sollte zur Erzielung einer kurzen Zykluszeit möglichst hoch sein, hohe Drucksprünge dabei aber zur Verhinderung einer Blasenbildung möglichst vermieden werden. Eine kurze Füllzeit kann alternativ auch durch einen großen Volumenstrom bei großer Einfüllöffnung erreicht werden, bei der die Injektionsgeschwindigkeit selbst aber gering gehalten wird.

Der Wirkungsgrad der in der oben beschriebenen Weise gefertigten Test-Solarmodule wurde unter einem Solarsimulator mit einem sonnenähnlichen Spektrum gemessen und betrug vor und nach der Umspritzung mit transparentem Polyurethan jeweils 10.5 %.

Die beschriebenen Solarmodule wurden unter den in der Tabelle 1 dargestellten Verfahrensbedingungen hergestellt:

**Tabelle 1**

| | |
|---|---|
| Injektionszeit [s] | 1 |
| Werkzeugtemperatur [°C] | 90 |
| Vermischungsdruck [bar] | 200 |
| Formzeit [s] | 60 |

### Beispiel 2

Zur Verkapselung von zwei miteinander verlöteten Solarzellen mit einer Fläche von je ca. 5×5 cm² mit transparentem Polyurethan wird in diesem Falle ein Gießverfahren gewählt. Als Rückseite dient eine glasfaserverstärkte Polycarbonatplatte (Dicke ca. 3 mm). Die Solarzellen werden mittels Klebstoff auf der Rückseite befestigt. Alternativ kann die Formgebung der Rückseite z.B. durch Vertiefungen zu einer Fixierung der Solarzellen genutzt werden. Nach der Fixierung der Solarzellen wird das transparente Polyurethansystem auf die Solarzellen aufgegossen. Dabei wird durch einen geeigneten Mischkopf eine homogene Vermischung der beiden Komponenten realisiert. Eingesetzt wurde ein Reaktionsgemisch der Rheinchemie GmbH bestehend aus einem aliphatischen Polyisocyanat RC-DUR 302 (HDI-Trimerisat, Biuret-Verbindung, Viskosität bei 23°C ca. 2500 mPa·s, NCO-Gehalt 23 %, monomeres HDI <0.5 %, Äquivalentgewicht 183 g/mol, Dichte 1.13 g/cm³) und einem Caprolacton-Polyol RC-PUR KE 9675 (Viskosität bei 23°C ca. 800 mPa·s, Hydroxylzahl 310, Wassergehalt <0.05 %, Äquivalentgewicht 540 g/mol, Dichte 1.1 g/cm³). Die Aushärtezeit des Reaktionsgemisches betrug etwa 2-3 Minuten. Es wurde eine vollkommen blasenfreie Einbettung der Solarzellen realisiert. Die Oberfläche der transparenten Polyurethanschicht war eben, die Schichtdicke betrug ca. 2-3 mm.

Der Wirkungsgrad des Solarmoduls wurde wie in Beispiel 1 ebenfalls unter einem Solarsimulator gemessen und betrug vor und nach der Einbettung mittels Gießverfahren in transparentes Polyurethan jeweils 12.1 %.

## Patentansprüche

1. Solarmodul, bei dem die Frontseite (1) aus transparentem Polyurethan besteht.

2. Solarmodul nach Anspruch 1, bei dem die darin enthaltenen Solarzellen (3) vollständig in transparentes Polyurethan eingebettet sind.

3. Solarmodul nach Anspruch 1, bei dem die Rückseite (5) aus einem Formteil aus Kunststoff, Glas oder Keramik besteht.

4. Solarmodul nach Anspruch 1, bei dem die Rückseite (5) aus einem Formteil aus opakem Polyurethan besteht.

5. Solarmodul nach Anspruch 4, bei dem das opake Polyurethan Füllstoffe, vorzugsweise Kreide, Glasplättchen und/oder Silikate, enthält.

6. Solarmodul nach einem der Ansprüche 1 bis 5, bei dem die Frontseite (1) eine texturierte Oberfläche aufweist.

7. Solarmodul nach einem der Ansprüche 1 bis 6, bei dem die Rückseite (5) in Form von Kühlrippen ausgebildet ist.

8. Verfahren zur Herstellung von Solarmodulen nach einem der Ansprüche 1 bis 7, bei dem das Polyurethan mittels eines Reaction Injection Moulding - Verfahrens, eines Gießverfahrens, eines Spritzprägeverfahrens oder Kombinationen daraus auf die Solarzellen aufgetragen wird.

9. Verfahren zur Herstellung von Solarmodulen nach Anspruch 8, bei dem die Solarzellen auf der Rückseite (5) des Moduls befestigt werden und anschließend die transparente Polyurethan-Frontseite (1) aufgespritzt oder gegossen wird.

10. Verfahren zur Herstellung von Solarmodulen nach Anspruch 8, bei dem die Rückseite (5) des Moduls, bestehend aus einer Kunststofffolie oder einer Verbund-Kunststofffolie, zusammen mit den Solarzellen tiefgezogen werden, so dass die Solarzellen durch den Tiefziehprozess auf der Rückseite (5) des Moduls befestigt werden.
